Europäisches Patentamt

European Patent Office

Office européen des brevets

(19)

(11) Veröffentlichungsnummer: **0 013 706**
**B1**

(12) **EUROPÄISCHE PATENTSCHRIFT**

(45) Veröffentlichungstag der Patentschrift: **18.01.84**

(21) Anmeldenummer: **79104615.4**

(22) Anmeldetag: **20.11.79**

(51) Int. Cl.³: **G 08 B 19/00,** G 08 G 1/12, G 01 R 31/36

(54) Einrichtung zur automatischen Überwachung des Ladezustandes der netzunabhängigen Stromversorgung und der Luftfeuchte im Antwortgerät einer Anlage zur Standortbestimmung von Verkehrseinrichtungen.

(30) Priorität: **22.12.78 DE 2855809**

(43) Veröffentlichungstag der Anmeldung:
**06.08.80 Patentblatt 80/16**

(45) Bekanntmachung des Hinweises auf die Patenterteilung:
**18.01.84 Patentblatt 84/3**

(84) Benannte Vertragsstaaten:
**BE CH DE FR GB IT NL SE**

(56) Entgegenhaltungen:
**EP - A - 0 004 969**
**DE - A - 2 022 447**
**FR - A - 2 256 409**
**FR - A - 2 287 038**
**US - A - 3 401 373**

**IEEE TRANSACTIONS ON VEHICULAR TECHNOLOGY, Band VT-19, Nr. 1, Februar 1970, W.V. BRAUN et al.: ''Vehicular location and information systems'', Seiten 136-143**

(73) Patentinhaber: **SIEMENS AKTIENGESELLSCHAFT**
**Berlin und München Wittelsbacherplatz 2**
**D-8000 München 2 (DE)**

(72) Erfinder: **Hildebrandt, Bernhard**
**Kirschstrasse 15**
**D-8046 Hochbrück (DE)**

Courier Press, Leamington Spa, England.

Einrichtung zur automatischen Überwachung des Ladezustandes der netzunabhängigen Stromversorgung und der Luftfeuchte im Antwort-gerät einer Anlage zur Standortbestimmung von Verkehrseinrichtungen

Die Erfindung bezieht sich auf eine Einrichtung zur automatischen Überwachung des Ladezustandes der netzunabhängigen Stromversorgung des stationären Antwortgerätes einer Anlage zur Standortbestimmung von Verkehrseinrichtungen, das mit einem in der Verkehrseinrichtung installierten Abfragegerät in Funkkontakt steht und wechselseitig Datentelegramme austauscht, wobei die Stromversorgungseinheit, bestehend aus Primärbatterien oder Akkumulatoren mit Ladung über Solarzellen, mit einer Überwachungsschaltung verbunden ist mit einer Ansprechschwelle zur Abgabe eines Alarmsignales, die um einen definiert einstellbaren Wert über der für den ungestörten Betrieb erforderlichen Mindestspannung liegt, und wobei das Ergebnis der bei jedem Abfragevorgang des Abfragegerätes durchgeführten Messung der Spannung als Überwachungssignal einem Telegrammregister zugeführt und in codierter Form dem vom Antwortgerät an das Abfragegerät übermittelten, die Streckendaten enthaltenden Telegramm beigefügt ist.

Punktförmige Ortungssysteme, die zur Standortbestimmung von Verkehrseinrichtungen eingesetzt sind, bestehen im wesentlichen aus zwei Einheiten, nämlich einem Abfragegerät und einem Antwortgerät. Die Abfragegeräte werden im allgemeinen mit Strom aus dem Bordnetz der Verkehrseinrichtung betrieben. Die Energieversorgung der Antwortgeräte aus einem Stromnetz ist mit einem hohen Aufwand für die Installation verbunden. Es ist daher vorgesehen, diese aus Primärbatterien oder aus Akkumulatoren mit Ladung über Solarzellen zu betreiben. Störungen in der Stromversorgung, beispielsweise entladene Batterien, werden durch fehlende Datensendung des jeweiligen Antwortgerätes erkannt und können nur über eine Plausibilitätskontrolle der Reihenfolge der Antwortgerätedaten an der Strecke in einer Zentrale festgestellt werden. Der Übergangszustand der Batterieladung von voll nach leer wird dabei nicht erkannt. Entsprechend der jeweiligen Verkehrsdichte wird die Batteriebelastung der Antwortgeräte längs einer Strecke unterschiedlich sein. Antwortgeräte z.B. an Kreuzungen und Plätzen werden häufiger abgefragt als solche, die z.B. an einbahnigen Straßen montiert sind.

Eine Einrichtung der eingangs beschriebenen Art zur automatischen Überwachung des Ladezustandes einer netzunabhängigen Stromversorgung ist durch die europäische Patentschrift Nr. 0004969 bekannt.

Die Funktionssicherheit bei einem solchen punktförmigen Ortungssystem, bei dem Daten vom Antwortgerät zum Lesegerät durch modulierte Mikrowellensignale übertragen werden, hängt außer von der netzunabhängigen Stromversorgung natürlich von einer sicheren Funktion der Mikrowellenschaltung in diesen Geräten ab. Diese kann, beispielsweise bei Gehäuseschäden, durch Feuchtebelag stark beeinträchtigt werden. Dadurch können sofortige Ausfälle eintreten, aber auch langsam verlaufende, bei denen erst durch Korrosion metallische Schaltungsteile ihre elektrischen Daten verändern. Dadurch kann die Betriebssicherheit des Systems über längere Zeit beeinträchtigt werden. Der schädliche Einfluß durch die Feuchte kann hierbei erst mit dem Ausfall der Betriebsfunktion des schadhaften Gerätes festgestellt werden.

Der Erfindung liegt daher die Aufgabe zugrunde, eine Einrichtung der eingangs beschriebenen Art dahingehend zu verbessern, daß auch eine Überwachung der Luftfeuchte im Gerät erfolgt.

Diese Aufgabe wird gemäß der Erfindung in der Weise gelöst, daß zur zusätzlichen Luftfeuchteüberwachung des Innenraums des Antwortgerätes ein nahe der zu überwachenden Mikrowellenschaltung angeordneter, bei Überschreiten eines vorgegebenen Grenzwertes der Luftfeuchte ansprechender Sensor vorgesehen ist, dessen Steuersignal über eine Transistorschaltung in ein Binärsignal umgesetzt wird, das über ein mit dem Überwachungssignal für die Versorgungsspannung verknüpftes ODER-Gatter in das Antworttelegramm eingeleitet wird.

Vorteilhafte Ausgestaltungen und Weiterbildungen des Erfindungsgegenstandes sind in den abhängigen Ansprüchen angegeben.

Nachstehend wird die Erfindung anhand eines in der Zeichnung dargestellten Ausführungsbeispieles näher erläutert.

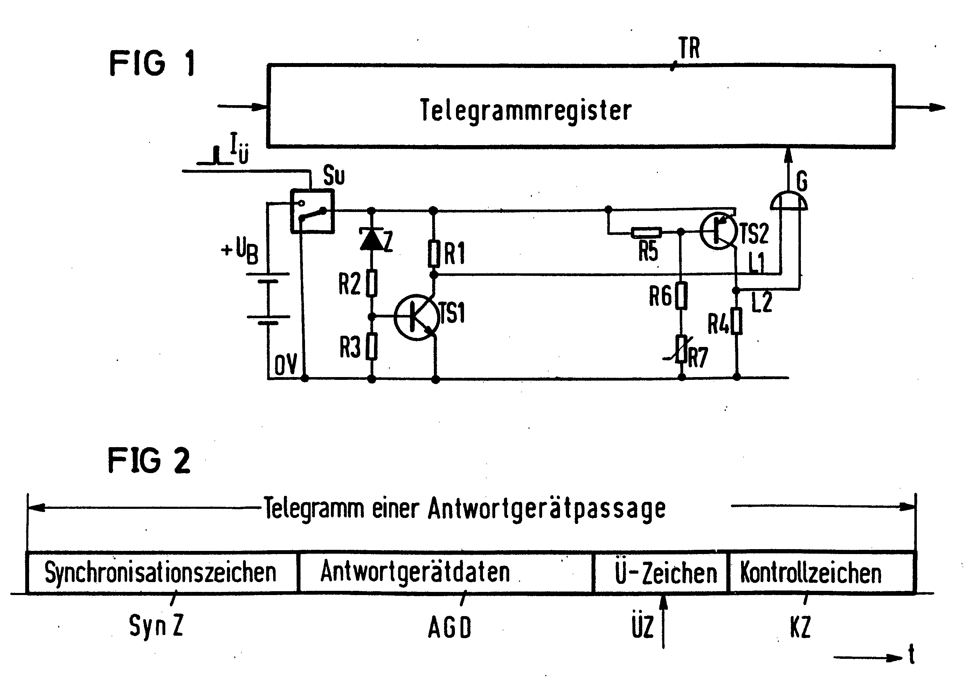

Fig. 1 zeigt die vollständige Überwachungsschaltung des Antwortgerätes. Dabei ist parallel zur Batterie mit den Klemmen $+U_B$ und O ein erster Transistor TS1 vom Typ npn geschaltet mit einem Stannungsteiler aus den Widerständen R2 und R3 im Basiskreis, einer in Reihe mit dem einen Widerstand R2 liegenden Zenerdiode Z und einem Widerstand R1 im Kollektorkreis. Vom Kollektor des Transistors TS1 führt eine Leitung L1 an den einen Eingang eines ODER-Gatters G, dessen Ausgang an ein Telegrammregister TR angeschlossen ist. Über diese Leitung L1 gelangt ein Überwachungssignal zum Telegrammregister TR. Die Bemessung dieser der Überwachung der Batterie dienenden Überwachungsschaltung ist dabei so gewählt, daß bei Erreichen eines bestimmten Spannungswertes (Alarmspannung) der Transistor TS1 sperrt.

Zur Überwachung der Luftfeuchte ist die Schaltung in folgender Weise ergänzt. Parallel zur Emitter-Kollektorstrecke des ersten Transistors TS1 ist ein zweiter Transistor TS2 (pnp-Typ) geschaltet mit einem Spannungsteiler aus den Widerständen R5 und R6 im Basiskreis, einem mit dem einen Widerstand R6 in Reihe liegenden feuchteabhängigen Widerstand R7 und einem Widerstand R4 im Kollektorkreis. Der Kollektor des Transistors TS2 ist mit dem zweiten Eingang des ODER-Gatters G verbunden. Im Weg der Batteriespannung ist ein Umschalter Su eingeschaltet, der von einem Überwachungsimpuls Iü betätigt wird und lediglich kurzzeitig ($\ll 1\%o$) innerhalb des Telegrammablaufs die Anschaltung der Überwachungsschaltungen vornimmt. Die dargestellte Lage des Umschalters gilt für den Fall, daß beide Überwachungsschaltungen, nämlich die für die Batteriespannung und die für die Luftfeuchte, nicht aktiv sind. Die Überwachungsschaltungen mit den Transistoren TS1 und TS2 sind dabei ohne Betriebsspannung; an den Gattereingängen liegen über die Leitung L1 und den Widerstand R1 sowie über die Leitung L2 und den Widerstand R4 eine logische "0" (OV). Mit dem Überwachungsimpuls Iü legt der Schalter Su für kurze Zeit Betriebsspannung an die Überwachungsschaltungen. Ist die Spannung $U_B$ unter einen vorgegebenen Schwellwert abgesunken, so daß im Verlauf des Überwachungsimpulses Iü die Zenerdiode Z nicht mehr leitend wird, liegt am Gattereingang über die Leitung L1 und den Widerstand R1 eine logische "1" ($+U_B$). Liegt der Spannungswert von $+U_B$ noch über dem vorgegebenen Schwellwert, dann wird im Verlauf des Überwachungsimpulses Iü die Zenerdiode Z leitend und damit auch der Transistor TS1. Hierbei wird die Leitung L1 über den Transistor TS1 nach OV geschaltet und es erfolgt innerhalb des Überwachungsimpulses Iü kein Alarm.

Der Widerstandswert des feuchteabhängigen Widerstandes R7 hängt sehr stark, möglichst mit logarithmischem Verlauf, von der Luchtfeuchte ab, und zwar derart, daß der Widerstandswert kleiner wird bei zunehmender Luftfeuchte. Eine Verkleinerung des Widerstandes R7 bewirkt, daß der Transistor TS2 leitend wird und über die Leitung L2 ein Signal in Form einer logischen "1" an das ODER-Gatter G gibt. Zur Einsparung von Betriebsstrom wird der Transistor TS2 wie der Transistor TS1 nur innerhalb des Überwachungsimpulses Iü mittels des Umschalters Su an die Betriebsspannung $+U_B$ angelegt. Der Innenraum des Mikrowellengerätes enthält, bei Auslieferung oder nach durchgeführten Wartungsarbeiten, Luft mit möglichst niedriger Feuchte.

In dem Telegrammregister TR wird das Überwachungszeichen dem Telegramm des Antwortgerätes hinzugefügt. Fig. 2 zeigt ein solches Telegramm, das aus mehreren aneinandergefügten Blöcken besteht, nämlich dem Synchronisationszeichen SynZ, den Antwortgerätedaten AGD, dem Überwachungszeichen ÜZ und einem Kontrollzeichen KZ. Auf jede Anfrage des Abfragegerätes wird diesem ein solches Telegramm vom Antwortgerät übermittelt. Die Zentrale ist somit ständig über mögliche Störungen im Antwortgerät informiert.

## Patentansprüche

1. Einrichtung zur automatischen Überwachung des Ladezustandes der netzunabhängigen Stromversorgung des stationären Antwortgerätes einer Anlage zur Standortbestimmung von Verkehrseinrichtungen, das mit einem in der Verkehrseinrichtung installierten Abfragegerät in Funkkontakt steht und wechselseitig Datentelegramme austauscht, wobei die Stromversorgungseinheit, bestehend aus Primärbatterien oder Akkumulatoren mit Ladung über Solarzellen, mit einer Überwachungsschaltung (TS1, Z, R1, R2, R3) verbunden ist mit einer Ansprechschwelle zur Abgabe eines Alarmsignals, die um einen definiert einstellbaren Wert über der für den ungestörten Betrieb erforderlichen Mindestspannung liegt, und wobei das Ergebnis der bei jedem Abfragevorgang des Abfragegerätes durchgeführten Messung der Spannung ($U_B$) als Überwachungssignal einem Telegrammregister (TR) zugeführt und in codierter Form dem vom Antwortgerät an des Abfragegerät übermittelten, die Streckendaten enthaltenden Telegramm beigefügt ist, dadurch gekennzeichnet, daß zur zusätzlichen Luftfeuchteüberwachung des Innenraums des Antwortgerätes ein nahe der zu überwachenden Mikrowellenschaltung angeordneter, bei Überschreiten eines vorgegebenen Grenzwertes der Luftfeuchte ansprechender Sensor (R7) vorgesehen ist, dessen Steuersignal über eine Transistorschaltung (TS2) in ein Binärsignal umgesetzt wird, das über ein mit dem Überwachungssignal für die Versorgungsspannung verknüpftes ODER-Gatter (G) in das Antworttelegramm eingeleitet wird.

2. Einrichtung nach Anspruch 1, dadurch gekennzeichnet, daß der Sensor (R7) aus einem ohmschen Widerstand besteht, dessen Widerstandswert sehr stark, vorzugsweise mit logarithmischem Verlauf, von der Luftfeuchte abhängt.

3. Einrichtung nach Anspruch 1 oder 2, dadurch gekennzeichnet, daß die Überwachungsschaltungen nur kurzzeitig ($\ll 1\%o$) innerhalb des Telegrammablaufs angeschaltet sind.

4. Einrichtung nach Anspruch 3, dadurch gekennzeichnet, daß in der Zuführungsleitung der Batteriespannung ($+U_B$) ein von einem Überwachungsimpuls (Iü) betätigter Umschalter (Su) angeordnet ist.

## Revendications

1. Dispositif pour la surveillance automatique de l'état de charge de l'alimentation en courant, indépendante du réseau, de l'appareil répondeur fixe d'une installation de localisation de véhicules de transport, qui est en contact radioélectrique et échange alternativement des télégrammes de données avec un appareil interrogateur installé dans le véhicule de transport, et dans lequel l'unité d'alimentation en courant, constituée par des batteries primaires ou des accumulateurs, chargés par l'intermédiaire de piles solaires, est reliée à un circuit de surveillance (TS1, Z, RA, R2, R3) possédant un seuil de réponse pour la délivrance d'un signal d'alarme qui est supérieur, d'une valeur réglable de façon définie, à la tension minimale nécessaire pour le fonctionnement non perturbé, et dans lequel le résultat de la mesure de la tension ($U_B$), effectuée lors de chaque processus d'interrogation de l'appareil interrogateur, est envoyé en tant que signal de surveillance un registre de télégrammes (TR) et est joint sous forme codée au télégramme retransmis par l'appareil répondeur à l'appareil interrogateur et contenant les données de la voie, caractérisé en ce que pour la surveillance supplémentaire de l'humidité de l'air de l'espace intérieur de l'appareil répondeur, il est prévu un capteur (R7) disposé à proximité du circuit à micro-ondes devant être surveillé et répondant lors du dépassement d'une valeur limite prédéterminée de l'humidité de l'air et dont le signal de commande est converti par un circuit à transistors (TS2) en un signal binaire qui est inséré dans le télégramme de réponse par l'intermédiaire d'une porte OU (G) combinée logiquement avec le signal de surveillance pour la tension d'alimentation.

2. Dispositif suivant la révendication 1, caractérisé en ce que le capteur (R7) est constitué par une résistance ohmique dont la valeur dépend très fortement, de préférence selon une allure logarithmique, de l'humidité de l'air.

3. Dispositif selon la revendication 1 ou 2, caractérisé en ce que les circuits de surveillance ne sont raccordés que pendant un intervalle de temps (≪1‰) pendant le déroulement du télégramme.

4. Dispositif selon la revendication 3, caractérisé en ce qu'un commutateur (Su) actionné par une impulsion de surveillance (Iü) est disposé dans la ligne d'amenée de la tension ($+U_B$) de la batterie.

**Claims**

1. A device for automatically monitoring the charge state of a mains-independent current supply of the stationary responder of an arrangement which serves to determine the location of traffic equipment which is in radio contact with an interrogation device, which is installed in the traffic equipment, and reciprocally exchanges data telegrams, where the current supply unit consisting of primary batteries or charged accumulators are connected via solar cells to a monitoring circuit (TS1, Z, R1, R2, R3) having a response threshold for transmitting an alarm signal, which threshold lies above the minimum voltage required for the undisturbed operation by a determinately adjustable value, and where the result of the measurement of the voltage ($U_B$) carried out in each interrogation process of the interrogation device, is fed to a telegram register (TR) as a monitoring signal, added to the telegram which contains the path data and transmitted from the reply device to the interrogation device in coded form characterized in that in order to additionally monitor the atmospheric humidity of the interior of the responder, there is provided a sensor (R7) arranged close to the micro-wave circuit to be monitored, and which responds when a given limit value of the atmospheric humidity is exceeded, and whose control signal is converted via a transistor circuit (TS2) into a binary signal which is inserted into the reply telegram by means of an OR-gate (G) linked to the monitoring signal for the supply voltage.

2. A device as claimed in Claim 1, characterized in that the sensor (R7) consists of a nonreactive resistor whose resistance value essentially depends upon the atmospheric humidity, preferably with a logarithmic course.

3. A device as claimed in Claim 1 or 2, characterised in that the monitoring circuits are only temporarily (≪1‰) switched on within the telegram run.

4. A device as claimed in Claim 3, characterised in that a change-over switch (Su) operated by a monitoring pulse (Iü) is arranged in the supply line of the battery voltage ($+U_B$).

**FIG 1**

Telegrammregister  TR

**FIG 2**

Telegramm einer Antwortgerätpassage

| Synchronisationszeichen | Antwortgerätdaten | Ü-Zeichen | Kontrollzeichen |
|---|---|---|---|
| Syn Z | AGD | ÜZ | KZ |

t

0 013 706